# EUROPEAN PATENT APPLICATION

(11) **EP 3 723 125 A1**
(43) Date of publication of application: **14.10.2020**
(21) Application number: 19167844.0
(22) Date of filing: 08.04.2019
(51) Int. Cl.: H01L 25/07, H01L 25/18, H01L 23/29, H01L 23/00

(54) **POWER ELECTRONIC MODULE AND METHOD OF MANUFACTURING A POWER ELECTRONIC MODULE**

(71) Applicant: ABB Schweiz AG, 5400 Baden (CH)
(72) Inventor: Manninen, Jorma, 00380 Helsinki (FI); Silvennoinen, Mika, 00380 Helsinki (FI); Pakarinen, Joni, 00980 Helsinki (FI)
(74) Representative: Kolster Oy Ab

(57) **Abstract**

A power electronic module and a method of manufacturing a power electronic module comprising at least one semiconductor chip attached to a substrate and at least one bond wire attached to the at least one semiconductor chip. The power electronic module comprises potting material disposed on top of the substrate and the at least one semiconductor chip, the potting material comprising elastic polymer with solid particles for supporting the at least one bond wire.

## Description

### FIELD OF THE INVENTION

The present invention relates to a power electronic module, and particularly to a power electronic module with increased thermal properties.

### BACKGROUND OF THE INVENTION

Power electronic semiconductor switches generate high amount of heat due to the internal power losses. These power losses are generated mainly in the area of semiconductor chips which have a surface area of couple of square centimetres. As the power losses are generated in a small area, the power loss density can be higher than 100 W/cm2 and the total losses may be in the range of several hundreds of watts to even thousand watts. The high losses lead to high temperatures of the semiconductor chips. The temperature of the chip may rise even up to 175°C.

Power electronic modules are built to lead the generated heat through the base plate of the module to an external heat sink as efficiently as possible. The different materials in the mechanical structure of power electrical modules have different physical properties, such as thermal expansion coefficient, density, thermal capacity and thermal conductivity. These different properties lead to mechanical stresses during use of the module. Specifically, the temperature variations of the power electronic module due to high and fast variations in power of the module stress the mechanical structure of the module, such as bond wires of the module. The stresses due to temperature variations can finally damage the module and lead to breakage of the power electronic module.

One of the critical structural elements in a power electronic module are the bond wires. A bond wire is used for connecting electrically the semiconductor chip to another structural part of the power electronics module. A bond wire may be used to connect two semiconductor chips together or to connect a semiconductor chip to a terminal of the power electronics module, for example. The bond wires are attached to the semiconductor chip typically by using solder to form an electrical connection. The mechanical failure of the bond wire is typically due to fatigue caused by shear forces between the solder material and the bond wire or repeated deformations of the bond wire.

Typical power electronic module has a substrate on top of which semiconductor chips are attached. The other surface of the substrate is used as a cooling surface and the heat from the chips is lead through the surface. Some power electronic modules have a base plate attached to the cooling surface of the substrate while in some constructions an external heat sink is to be attached directly to the cooling surface. The substrate and the chips are covered with a housing of the module. Further, the substrate and chips may be covered with a gel like layer to protect the chips from moisture and small particles which may enter the module.

An attempt to alleviate the problem relating to breakage of the bond wires is to use resin on top of the substrate and the chips, i.e. to fill the housing of the module at least partly with the resin. The resin holds and ties the bond wires tightly in their place and gives support to the bond wires. However, forces which are due to the different thermal expansion coefficients of the structural parts of the module are transmitted with the resin to the bond wire. Although the bond wires are supported by the resin, the bond wires are subjected to forces which may cause the bond wires to break.

### BRIEF DESCRIPTION OF THE INVENTION

An object of the present invention is to provide a power electronic module and a method of manufacturing a power electronic module so as to solve the above problem. The object of the invention is achieved by a power electronic module and a method which are characterized by what is stated in the independent claims. The preferred embodiments of the invention are disclosed in the dependent claims.

The invention is based on the idea of using solid particles in a matrix material disposed on top of the substrate and the semiconductor chips. Solid particles are mixed in the matrix material, such as elastic polymer, to form a potting or filling material which is placed inside the housing of a power electronic module. The solid particles together with the matrix material provide support to the bond wires. While supporting the bond wires, the mixture allows the structural parts of the module to change their shape and dimensions due to temperature variations and differing thermal expansion coefficients without affecting the shape of the bond wires. That is, the material mixture does not transmit the temperature related forces to the bond wires due to elasticity of the material mixture.

With the method of the invention, a power electronic module of the invention can be manufactured.

According to an embodiment of the invention, the elastic polymer is silicone gel and the solid particles are electrically insulating particles. The electrically insulating particles are preferably aerogel particles.

### BRIEF DESCRIPTION OF THE DRAWINGS

In the following the invention will be described in greater detail by means of preferred embodiments with reference to the accompanying drawings, in which
Figure 1 shows a cross section of an example of a power electronic module; and
Figure 2 shows a detail of a bond wire in a power electronic module of the invention.

### DETAILED DESCRIPTION OF THE INVENTION

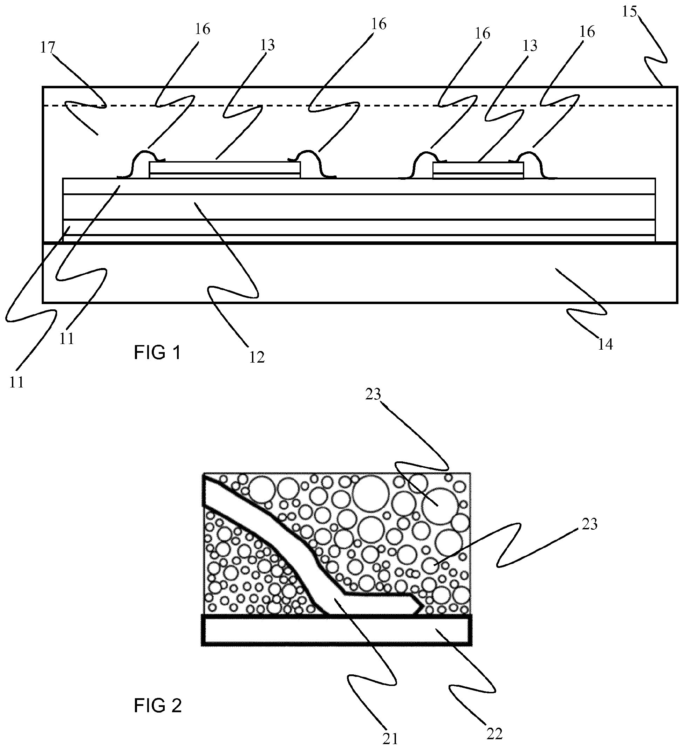

Figure 1 shows an example of a power electronic module of an embodiment. The module comprises a substrate, such as direct bonded copper substrate (DBC) which consists of a two copper layers 11 and a ceramic layer 12 between the copper layers. Further, the module of Figure 1 comprises a semiconductor chip 13. The cross section of Figure 1 shows two semiconductor chips 13. The semiconductor chips may be any semiconductor switch devices, such as IGBT chips or diode chips. The semiconductor chips are arranged on top surface of the substrate and the bottom surface acts as a cooling surface. The cooling surface may be attached directly to an external heat sink. In other type of module, the cooling surface may be attached to a baseplate 14. The baseplate forms the outer surface of the module and can be attached to an external heat sink.

The substrate and the semiconductor chips are surrounded by a housing 15 which is gives mechanical protection to the electrical components. Figure 1 also shows multiple of bond wires 16 which are attached to semiconductor chips. The purpose of a bond wire is to connect electrically the semiconductor chip to another element in the module. A bond wire may connect semiconductor chips together or connect semiconductor chips to terminals which extend outside the housing. In Figure 1, the bond wires are shown to connect the semiconductor chips to the surface of the substrate.

Figure 1 also shows potting material 17 which is disposed on top of the substrate and the semiconductor chips. The potting material refers to a material which is placed on top of a circuit board or similar to cover and to protect the circuit structures. The top of the layer of potting material in Figure 1 is shown as a dashed line. The thickness of the layer can vary from a thin layer to a layer which fills the housing of the module completely.

According to the present invention, the power electronic module comprises at least one semiconductor chip attached to a substrate and at least one bond wire attached to the at least one semiconductor chip. A power electronic module may also comprise multiple of substrates, multiple of semiconductor chips and multiple of bond wires. Further, the multiple of bond wires may be connected to a single semiconductor chip.

Further, according to the present invention, the power electronic module comprises potting material disposed on top of the substrate and the at least one semiconductor chip. The potting material comprises elastic polymer with solid particles for supporting the at least one bond wire.

Figure 2 shows a simplified and enlarged view of a bond wire 21 which is attached to a surface of a semiconductor chip 22. Figure 2 also shows solid particles 23 in the elastic polymer. The solid particles are shown as circles in the drawing. It should be noted that Figure 2 is not drawn in scale and the sizes of the solid particles is highly exaggerated. The solid particles are shown to have different sizes. The elastic polymer is preferably silicone gel. Silicone gel tolerates heat and is suitable material to be used as a matrix material. The physical properties of potting material, i.e. the combination of the elastic polymer and the solid particles, can be changed by changing the amount and size distribution of solid particles. The increase of concentration of solid particles increases the viscosity and / or dynamic modulus (toughness) of the potting material. According to an embodiment of the invention, the concentration of solid particles, and more specifically silicon aerogel particles, is higher than 5%. The concentration refers to amount of solid particles in the total volume of the potting material.

The size of the solid particles can vary from couple of nanometres to tens of micrometres. Preferably the solid particles are aerogel particles and typically silicon aerogel particles. In a typical silicon aerogel powder the size of the particles varies from sizes less than one micrometre to sizes up to 50 micrometres. Also other particles that are electrically resistive can be used in the invention. Use of silica aerogel is preferred as it is both thermally and electrically highly resistive. An example of another suitable material that may be used as solid particles is alumina (Al₂O₃). Also other aerogels can be used as solid particles in the potting material.

The potting material of the invention supports the bond wires near the soldering points of the bond wires. Further, the potting material of the invention does not transmit the forces emerging from the different temperature coefficients of the power electronic module to the solder joints. Further, the potting material permits the small movement of the bond wires due to their own temperature changes.

The present invention also relates to manufacturing of a power electronic module. In the method, a substrate with a semiconductor chip with at least one bond wire is provided. Further in the method, a potting material is dispensed on top of the substrate and the semiconductor chip and the potting material comprises elastic polymer with solid particles for supporting the at least one bond wire. The potting material used in the invention can be dispensed on the substrate with typical tools which are used for dispensing elastic polymers. The method of the invention produces a power electronic module described above. According to an embodiment of the method, the dispensed elastic material is silicone gel and the solid particles are silica aerogel particles. In an embodiment of the invention, the method comprises further producing the potting material by mixing elastic polymer with solid particles. Preferably the producing of the potting material comprises mixing silicone gel with silica aerogel particles. Preferable, the concentration of the silica aerogel particles is higher than 5% of the total volume of the potting material.

It will be obvious to a person skilled in the art that, as the technology advances, the inventive concept can be implemented in various ways. The invention and its embodiments are not limited to the examples described above but may vary within the scope of the claims.

## Claims

1. A power electronic module comprising
at least one semiconductor chip attached to a substrate,
at least one bond wire attached to the at least one semiconductor chip, wherein
the power electronic module comprises potting material disposed on top of the substrate and the at least one semiconductor chip, the potting material comprising elastic polymer with solid particles for supporting the at least one bond wire.

2. A power electronic module according to claim 1, wherein the solid particles are electrically insulating particles.

3. A power electronic module according to claim 1 or 2, wherein the solid particles are aerogel particles.

4. A power electronic module according to claim 3, wherein the aerogel particles are silica aerogel particles.

5. A power electronic module according to claim 1 or 2, wherein the solid particles are alumina particles.

6. A power electronic module according to any one of the previous claims 1 to 5, wherein the elastic polymer is silicone gel.

7. A power electronic module according to any one of the previous claims 1 to 6, wherein the concentration of solid particles in the potting material is higher than 5% of the total volume of the potting material.

8. A method of manufacturing a power electronic module, wherein the method comprises
providing a substrate with a semiconductor chip with at least one bond wire,
dispensing potting materiel on top of the substrate and the semiconductor chip, the potting material comprising elastic polymer with solid particles for supporting the at least one bond wire.

9. A method of manufacturing a power electronic module according to claim 8, wherein the method comprises further
producing the potting material by mixing elastic polymer with solid particles.

10. A method of manufacturing a power electronic module according to claim 9, wherein the producing of the potting material comprises mixing silicone gel with silica aerogel particles.

11. A method of manufacturing a power electronic module according to claim 10, wherein the concentration of the silica aerogel particles is higher than 5% of the total volume of the potting material.
